Europäisches Patentamt

European Patent Office

Office européen des brevets

(11) Publication number : **0 427 209 B1**

(12) **EUROPEAN PATENT SPECIFICATION**

(45) Date of publication of patent specification :
16.03.94 Bulletin 94/11

(51) Int. Cl.⁵ : **C04B 35/00, C04B 35/60, H01L 39/24**

(21) Application number : 90121230.8

(22) Date of filing : 06.11.90

(54) **Process for producing oxide superconductor.**

(30) Priority : 08.11.89 JP 291751/89

(43) Date of publication of application :
15.05.91 Bulletin 91/20

(45) Publication of the grant of the patent :
16.03.94 Bulletin 94/11

(84) Designated Contracting States :
DE FR GB

(56) References cited :
JAPANESE JOURNAL OF APPLIED PHYSICS, vol. 28, no. 7, July 1989, pages 1189-1194, Tokyo, JP; M. MURAKAMI et al.: "A new process with the promise of high Jc in oxide superconductors"
JAPANESE JOURNAL OF APPLIED PHYSICS, vol. 28, no. 3, March 1989, pages L399-L401, Tokyo, JP; M. MURAKAMI et al.: "Microstructural study of the Y-Ba-Cu-O system at high temperatures"
CHEMICAL ABSTRACTS, vol. 109, no. 6, 8th August 1988, page 295, left-hand column, abstract no. 42415p, Columbus, Ohio, US; J. TAKADA et al.: "Formation of barium copper yttrium oxide (YBa2Cu3Ox) by peritectic reaction", & FUNTAI OYOBI FUNMATSU YAKIN 1987, 34(10), 583-9
CHEMICAL ABSTRACTS, vol. 110, no. 8, 20th February 1988, page 461, left-hand column, abstract no. 64545d, Columbus, Ohio, US; T. ASELAGE et al.: "Liquidus relations in yttrium-barium-copper oxides", & J. MATER. RES. 1988, 3(6), 1279-91
JOURNAL OF THE CERAMIC SOCIETY OF JAPAN, INTERNATIONAL EDITION, vol. 97, no. 10, October 1989, pages 1014-1018, Tokyo, JP; K. SAWANO et al.: "Effects of synthesis conditions on microstructure of a YBa2Cu3Ox superconductor by partial melting process"
FILE SUPPLIER JAPS/JPO, PATENT OFFICE OF JAPAN; & JP-A-63 276 819 (NIPPON STEEL CORP.) 15-11-1988
WORLD PATENTS INDEX LATEST, accession no. 91-204695 [28], Derwent Publications Ltd, London, GB; & JP-A-3 130 106 (KOKUSAI CHODENDO) 03-11-1991

(73) Proprietor : INTERNATIONAL SUPERCONDUCTIVITY TECHNOLOGY CENTER No. 34-3, Shinbashi 5-chome Minato-ku Tokyo (JP)
Proprietor : Nippon Steel Corporation 6-3, 2-chome, Ote-machi Chiyoda-ku Tokyo 100 (JP)
Proprietor : SHIKOKU ELECTRIC POWER CO., INC. 2-5, Marunouchi, Takamatsu-shi Kagawa (JP)
Proprietor : RAILWAY TECHNICAL RESEARCH INSTITUTE 8-38, Hikaricho-2-chome Kokubunji-shi Tokyo (JP)

(72) Inventor : Murakami, Masato, c/o Superconductivity Res. Lab.
International Superconductivity Technology Center, 14-3, Chinonome 1-chome Koto-ku, Tokyo (JP)
Inventor : Oyama, Terutsugu, c/o Superconductivity Res. Lab.
International Superconductivity Technology Center, 14-3, Shinonome 1-chome Koto-ku, Tokyo (JP)
Inventor : Fujimoto, Hiroyuki, c/o Superconductivity Res. Lab
International Superconductivity Technology Center, 14-3, Shinonome 1-chome Koto-ku, Tokyo (JP)
Inventor : Koshizuka, Naoki, c/o Superconductivity Res. Lab.
International Superconductivity Technology Center, 14-3, Shinonome, 1-chome Koto-ku, Tokyo (JP)
Inventor : Shiohara, Yu, c/o Superconductivity Res. Lab.
International Superconductivity Technology Center, 14-3, Shinonome 1-chome Koto-ku Tokyo (JP)
Inventor : Tanaka, Shoji, c/o Superconductivity Res. Lab.
International Superconductivity Technology Center, 14-3, Shinonome 1-chome Koto-ku, Tokyo (JP)

㈤ Representative : Kador & Partner Corneliusstrasse 15 D-80469 München (DE)

## Description

BACKGROUND OF THE INVENTION

1. Field of the Invention

The present invention relates to a process for producing an oxide superconductor, particularly an oxide superconductor having a high critical current density (Jc), a well-oriented polycrystalline structure, and a good processability.

2. Description of the Related Art

The discovery of oxide superconductors of the YBaCuO-system having a critical temperature (Tc) higher than 90 K has made possible the use of liquid nitrogen as a coolant for providing a superconductive condition, and has activated a worldwide study of the practical application of such superconductors. Nevertheless, a practical application at liquid nitrogen temperatures has not been achieved, because the critical current density (Jc) is too low.

In a recent study by M. Murakami et al., Japanese Journal of Applied Physics, vol.28, 1989, p1189, it is stated that, if a superconductive phase is formed from a molten state, an almost practically applicable level of the critical current density of higher than 1000 $A/cm^2$ is obtained even under a magnetic field as high as 1 tesla (T).

The Murakami process utilizes the phenomenon that a superconductive phase $YBa_2Cu_3O_x$ (hereinafter referred to as "123-phase") is formed by a peritectic reaction between a $Y_2BaCuO_5$ phase (hereinafter referred to as "211-phase") and a liquid phase, and has succeeded in promoting the growth of the superconductife 123-phase by a fine and uniform dispersion of the 211-phase particles in a liquid phase; the finely dispersed 211-phase particles also acting as a pinning center of the magnetic flux through the superconductive phase. The fine and uniform dispersion of the 211-phase is ensured by a heat-treatment comprising a rapid heating to a temperature higher than 1200°C and a subsequent rapid cooling, to obtain a fine dispersion of a $Y_2O_3$-phase which acts as a nucleus for the formation of the 211-phase.

In a conventional process for producing an oxide superconductor exhibiting a superconductive behavior at higher temperatures, a rubber tube filled with source powders for producing an oxide superconductor is isostatically pressed in a cold isostatic pressure (CIP) apparatus to form a compact bar of a precursor of a superconductor, which is then subjected to a treatment for improving the superconductive properties of the bar, such as a sintering treatment, a unidirectional solidification, a floating zone process, a laser irradiation, or a plasma irradiation, etc.

These conventional processes, however, have a problem in that it is difficult to obtain a uniform dispersion of the $Y_2O_3$ because, during the heating at a temperature higher than 1200°C, the $Y_2O_3$ particles coalesce to form coarser particles while settling in the lower portion due to the greater density thereof than that of the coexisting liquid phase.

It is also difficult to obtain a product having a desired shape, because a plate produced by the rapid cooling has a limited shape.

The conventional processes for producing a superconductor precursor bar by using a CIP treatment also have a problem in that it is impossible to obtain a precursor bar having a uniform diameter and a good straightness, because the material in the rubber tube is imparted with an arbitrary shape determined by the natural contraction of the rubber tube and the source powders under a high pressure during the CIP treatment.

It is difficult to subject such an irregularly shaped precursor bar to a treatment for improving the superconductive properties, such as a unidirectional solidification, a floating zone process, etc.

In a unidirectional solidification, a precursor bar is inserted in a long crucible, and the bar is melted and a crystalline product is grown, but a curved bar cannot be inserted in the crucible. Although a curved bar may be inserted by cutting it into pieces, the discrete pieces cause the formation of bubbles, and as a result, a well-oriented polycrystalline product cannot be obtained.

In a floating zone process, a precursor bar must be rotated and a curved bar cannot ensure a constant temperature gradient, with the result that a well-oriented polycrystalline superconductor cannot be obtained.

In a CIP treatment for producing an oxide superconductor coil, a rubber tube and a superconductor precursor in the tube are contracted by the high pressure during the CIP treatment, and when the pressure is removed, are returned to the initial shape and thus causes a cracking of the coil in the tube. It is impossible to obtain a dense, uniform and crack-free superconductor coil having a well-oriented polycrystalline structure if such a cracked coil is subjected to a unidirectional solidification, a floating zone process, a laser irradiation, or a plasma irradiation, etc.

SUMMARY OF THE INVENTION

The object of the present invention is to provide a process for producing an oxide superconductor having a high critical current density (Jc), a well-oriented polycrystalline structure, and a good processability.

To achieve the object of the present invention, there is provided a process for producing an oxide superconductor of an REBaCuO-system, RE being one or more rare earth elements including yttrium, comprising the steps of:

preparing a solid mixture of oxides of the component elements of an oxide superconductor of an REBaCuO-system, the solid mixture having a chemical composition such that a structure substantially composed of an $RE_2BaCuO_5$ phase and a $REBa_2Cu_3O_x$ phase is formed in the later step of cooling;

heating the solid mixture to form a solid-and-liquid mixture of an $RE_2O_3$ phase and a liquid phase, or of an $REBa_2CuO_5$ phase and a liquid phase;

cooling the solid-and-liquid mixture to cause a peritectic reaction and form a solid body having a structure substantially composed of an $RE_2BaCuO_5$ phase and a $REBa_2Cu_3O_x$ phase;

pulverizing the solid body to form granules;

agitating the granules to an extent such that a fine and uniform dispersion of an $RE_2BaCuO_5$ phase in a liquid phase is obtained in the later step of re-heating;

filling the granules in a flexible tube;

applying a longitudinal tension to the flexible tube filled with the granules;

isostatically pressing the flexible tube, while maintaining the tension, to form a compact body;

relaxing the isostatic pressure and the longitudinal tension; and

subjecting the compact body to a treatment for promoting the growth of the $REBa_2Cu_3O_x$ phase therein, the treatment including the steps of re-heating the compact body to a temperature at which an $RE_2BaCuO_5$ phase and a liquid phase coexist, and then cooling the compact body to a temperature at which the $REBa_2Cu_3O_x$ phase and the $RE_2BaCuO_5$-phase coexist.

The solid mixture of oxides as the starting material used in a process according to the present invention is prepared by blending commercially available oxide powders or oxide powders obtained in a usual sintering process, at a predetermined proportion in accordance with the desired chemical composition of the oxide superconductor as a final product.

The flexible tube is preferably made of a flexible material such as rubber, copper, or silver.

The oxide superconductor of an REBaCuO-system according to the present invention may be in the form of a bar, a wire, a coil, or a block.

BRIEF DESCRIPTION OF THE DRAWINGS

Figure 1 shows a quasi-binary phase diagram of an oxide superconductor of an REBaCuO-system, RE being one of the rare earth elements including yttrium, according to the present invention;

Fig. 2 schematically illustrates a process for producing an oxide superconductor of an REBaCuO-system, according to the present invention;

Fig. 3 schematically illustrates another process for producing an oxide superconductor of an REBaCuO-system, according to the present invention;

Figs. 4 to 7 show a general assembly of an apparatus suitable for carrying out a process for producing an oxide superconductor, according to the present invention;

Fig. 8 shows precursor bars of a superconductor in a side view, according to the present invention;

Fig. 9 shows a process for producing a precursor wire of an oxide superconductor, according to the present invention;

Figs. 10 and 11 show a general assembly of an apparatus suitable for carrying out a process producing a precursor of an oxide superconductor, according to the present invention;

Fig. 12 shows a precursor coil of an oxide superconductor in a perspective view, according to the present invention;

Fig. 13 shows a process for producing a precursor coil of an oxide superconductor, according to the present invention; and

Fig. 14 shows a process for producing a precursor wire of an oxide superconductor, according to the present invention.

DESCRIPTION OF THE PREFERRED EMBODIMENTS

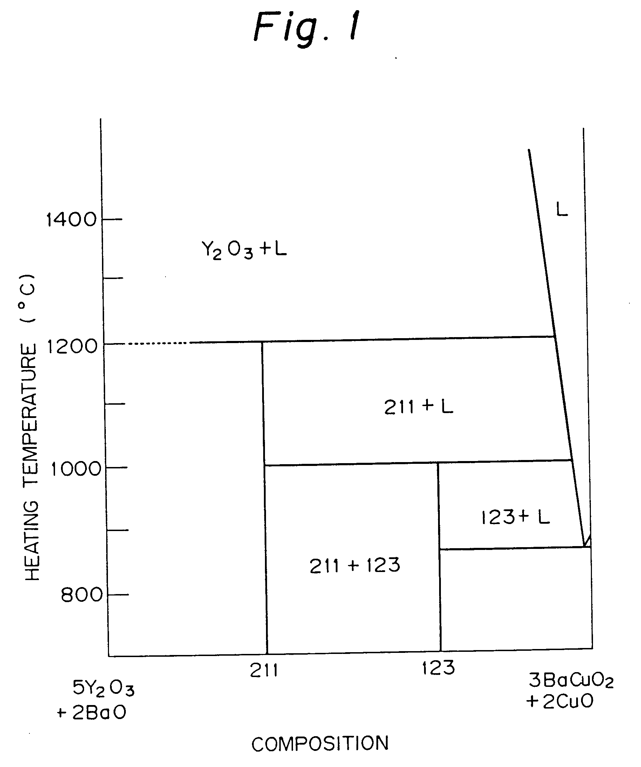

As seen from Fig. 1, which is a quasi-binary phase diagram, it is known that a superconductive phase is formed by a peritectic reaction between the 211-phase and a liquid phase substantially composed of BaO + CuO or $BaCuO_2$ + CuO (M. Murakami et al., Japanese Journal of Applied Physics, vol. 28, 1989, p399).

To ensure a continuous growth of a superconductive phase, both the 211-phase and the liquid phase should be supplied, and therefore, the former should be finely and substantially uniformly dispersed in the latter. A possible way of obtaining a uniform dispersion is to form a substantially uniform dispersion of an $RE_2O_3$-phase which acts as a nucleus for the formation of the 211-phase, and then form the 211-phase. Conventionally, such a uniform dispersion of the $RE_2O_3$-phase is obtained by a rapid heating to a temperature region of Fig. 1 in which the $RE_2O_3$-phase and the liquid phase are stable, but the $Y_2O_3$ particles tend to coalesce to form coarser particles and it is difficult to form a uniformly dispersed structure, i.e., a test sample as a whole contains nonuniform regions although some uniform regions are locally present.

Nevertheless, the present inventors found that it is possible to obtain a more uniform dispersion of $RE_2O_3$ than that of the rapidly cooled state, by pulverizing the cooled solid containing nonuniform regions and agitating the pulverized granules, and that a well developed uniform structure of the superconductive phase is obtained when the pulverized granules are re-heated to a temperature at which the 211-phase and a liquid phase coexist, in comparison with the conventional structure obtained by re-heating the as-cooled or nonpulverized solid. The inventors also found that, as long as the pulverization and agitation are carried out, a rapid cooling for freezing a high temperature structure is not necessary and, for example, an air cooling of a molten material in a crucible can also provide the same uniform structure.

In a preferred embodiment according to the present invention, a solid mixture of oxides of the component elements of an oxide superconductor of an REBaCuO-system is heated to a temperature at which the $RE_2O_3$-phase and a liquid phase coexist and then cooled rapidly or naturally to form a solid body, which is then pulverized to form granules having a diameter of 0.1 to 50 μm. The granules are agitated to an extent such that a fine and uniform dispersion of an $RE_2BaCuO_5$-phase in a liquid phase is obtained in the later re-heating step, and are filled in a flexible tube made of a flexible material such as rubber, copper, or silver. The flexible tube filled with the granules is subjected to a longitudinal tension, i.e., pulled in the longitudinal direction, and isostatially pressed while maintaining the longitudinal tension, to form a compact body or a precursor of a desired oxide superconductor in the form of a bar, a wire, a coil, or a block, for example. The compact body is re-heated to a temperature at which a $RE_2BaCuO_5$-phase (211-phase) and a liquid phase coexist, and during this reheating, a more uniform dispersion of the 211-phase is obtained in comparison with the conventional 211-dispersion obtained by re-heating an as-cooled or non-pulverized solid. After the re-heating, the compact body is cooled, preferably slowly, to a temperature at which the superconductive 123-phase and the 211-phase coexist as shown in Fig. 1, to form a superconductor having a well-developed structure of the superconductive 123-phase in which fine particles of the 211-phase are dispersed.

In another embodiment according to the present invention, a solid mixture of oxides of the component elements of an oxide superconductor of an REBaCUO-system is heated to a temperature at which the 211-phase and a liquid phase coexist. The structure obtained by this heating is somewhat coarser than that obtained by the first heating of the above-mentioned embodiment, but the later pulverization and mechanical agitation can provide substantially the same structure in which the 211-phase is uniformly dispersed. The thus-obtained granules are filled in a flexible tube and the tube is then subjected to a longitudinal tension and an isostatic pressing, in the same manner as in the first embodiment. The thus-obtained compact body, or a precursor of a desired oxide superconductor, is re-heated and cooled to cause the growth of the superconductive 123-phase and form a superconductor having a well-developed structure of the superconductive 123-phase in which the 211-phase is finely and uniformly dispersed, i.e., substantially the same structure as obtained in the first embodiment.

As described above, according to the present invention, a preliminary structure in which the 211-phase is finely and uniformly dispersed can be relatively easily obtained, and further, compact bodies having various shapes can be prepared from a solid-and-liquid mixture.

Moreover a bar or a coil of a superconductor precursor having a uniform diameter and a good straightness (in the case of a bar) is prepared by isostatically pressing a flexible tube filled with precursor granules of the superconductor while applying a longitudinal tension to the tube. The prepared precursor bar or coil is subjected to a unidirectional solidification, and a floating zone process, etc. to improve the superconductive properties and thereby form a dense, crack-free oxide superconductor having a well-oriented polycrystalline structure.

The thus-produced oxide superconductor according to the present invention has a high critical current density (Jc), a well-oriented polycrystalline structure, and a good processability.

The use of a flexible tube made of a metal having a low electrical resistivity, such as copper or silver, makes it easier to produce a superconductor precursor having a uniform diameter and a good straightness and coated with such a metal. It is known that such a metal coating on a superconductor stabilizes the superconductive properties, and further functions as a protective circuit when the superconductive state is broken.

The precursor compact body coated by the metal may be in the form of a bar, a wire, a coil, a block, or the like.

The coated precursor is treated by a unidirectional solidification, and a floating zone process, etc., to improve the superconductive properties and form a dense, crack-free and well-oriented polycrystalline superconductor coated with copper, silver, or other metal having a low electrical resistivity.

EXAMPLES

Example 1

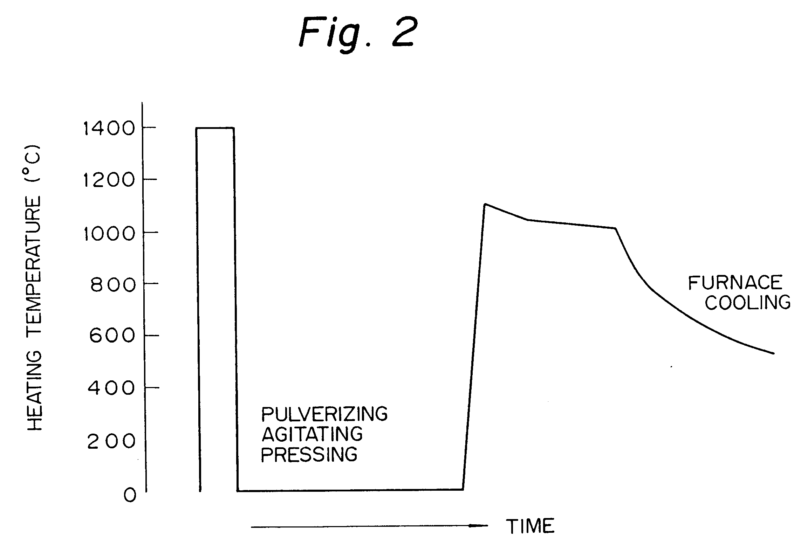

A process according to the present invention will be described with reference to Fig. 2.

$Y_2O_3$, $BaCO_3$, and $CuO$ powders were blended in a proportion of about 1:2:3 with respect to the cations, to form a solid mixture, and the solid mixture was then pre-heated at 900°C for 24 hours, heated at 1400°C for 10 minutes, and rapidly cooled to room temperature by using a copper hammer, to form a plate. The plate was pulverized to form granules, which were agitated to an extent such that a fine and uniform dispersion of an $Y_2BaCuO_5$ phase in a liquid phase can be obtained in the later re-heating step. The agitated granules were filled in a rubber tube, which was then subjected to a longitudinal tension, and isostatically pressed in a CIP apparatus while maintaining the tension, to form a pellet. The pellet was re-heated to 1100°C, cooled to 1000°C at a cooling rate of 100°C/hour, and slowly cooled to 950°C at a cooling rate of 5°C/hour, followed by a furnace cooling to room temperature. To obtain a sufficient oxygen content, the pellet was heated in air at 600°C for 1 hour and furnace-cooled.

The thus-obtained sample had a null-resistivity temperature of 93 K and exhibited a critical current density as high as 30000 A/cm$^2$ at 77 K in a magnetization test under a magnetic field of 1 tesla. The critical current density is far greater than the value of 10000 A/cm$^2$ obtained by a conventional process in which the pulverization and agitation are not used.

Example 2

A solid mixture prepared in the same manner as in Example 1 was placed in a platinum crucible, heated at 1300°C for 20 minutes in a furnace, taken out of the furnace, allowed to cool naturally in air, followed by a rapid cooling to room temperature. The thus-obtained block was pulverized to form granules, which were then agitated to an extent such that a fine and uniform dispersion of an $Y_2BaCuO_5$ phase in a liquid phase is obtained in the later re-heating step. The agitated granules were filled in a rubber tube, which was then subjected to a longitudinal tension, and isostatically pressed in a CIP apparatus while maintaining the tension, to form a 10 mm in dia. pellet. The pellet was re-heated to 1150°C, cooled to 1000°C at a cooling rate of 50°C/hour, slowly cooled to 950°C at a cooling rate of 2°C/hour, followed by a furnace cooling to room temperature.

The thus obtained sample had null-resistivity temperature of 93 K and exhibited a critical current density as high as 25000 A/cm$^2$ at 77 K in a magnetization test under a magnetic field of 1 tesla.

Example 3

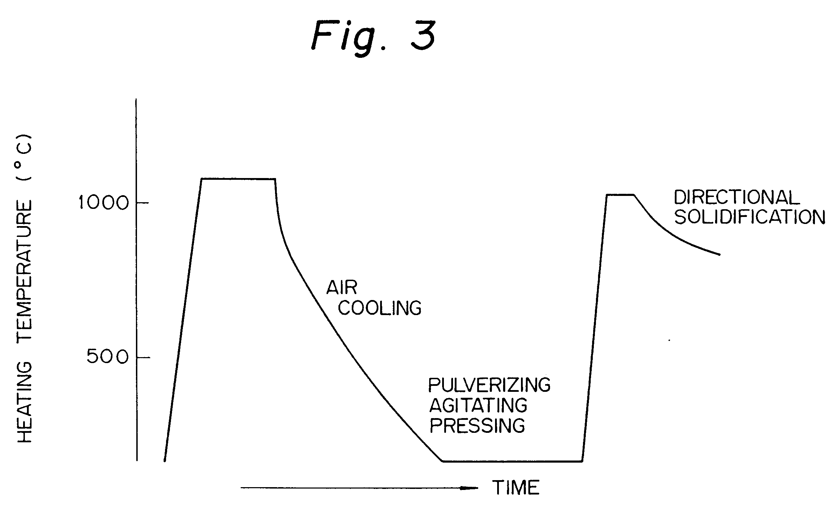

A process according to the present invention will be described with reference to Fig. 3.

$Ho_2O_3$, $BaCO_3$, and $CuO$ powders were blended at an Ho:Ba:Cu proportion of about 1:2:3, to form a solid mixture, and the solid mixture was heated at 1150°C for 1 hour and air-cooled to room temperature to form a solid. The solid was pulverized by a jet mill to form granules, which were agitated to an extent such that a fine and uniform dispersion of an $Ho_2BaCuO_5$ phase in a liquid phase is obtained in the later re-heating step. The agitated granules were filled in a rubber tube, which was then subjected to a longitudinal tension and isostatically pressed in a CIP apparatus while maintaining the tension, to form a bar. The bar was re-heated to 1100°C, cooled to 1000°C at a cooling rate of 50°C/hour, and slowly cooled to room temperature in a manner such that the bar was travelled in a furnace having a temperature gradient of 20°C/cm. This caused a unidirectional growth of a superconductive $HoBa_2Cu_3O_x$ phase.

The thus-obtained sample had a critical current density higher than 30000 A/cm$^2$ at 77 K, as determined by a four-terminal measurement using a pulse current source.

A substitution of the Ho site by other lanthanoid elements provided similar results, as summarized in Table 1.

Table 1

| RE in REBaCuO | Jc $(A/cm^2)$ |
|---|---|
| Y | 30000 |
| $Y_{0.5}Ho_{0.5}$ | 25000 |
| Dy | 28000 |
| Eu | 27000 |
| Sm | 26000 |
| Yb | 15000 |
| Gd | 24000 |
| Er | 28000 |
| Tm | 18000 |
| $Ho_{0.5}Eu_{0.5}$ | 20000 |
| $Dy_{0.5}Sm_{0.5}$ | 20000 |

As seen from the Examples 1 to 3, the process according to the present invention provides an oxide superconductor having a high critical current density achieved by the structure thereof in which fine particles of the $RE_2BaCuO_5$ phase are uniformly dispersed in the $REBa_2Cu_3O_x$ superconductive phase.

Such a fine and uniform dispersion of the $RE_2BaCuO_5$ phase in the $REBa_2Cu_3O_x$ phase is ensured by the pulverization and agitation step effected so that a fine and uniform dispersion of the $RE_2BaCuO_5$ phase in a liquid phase is obtained in the later step of re-heating to a temperature at which an $RE_2BaCuO_5$ phase and the liquid phase coexist.

After the pulverization and agitation in such a manner as in Examples 1 to 3, the agitated granules are filled in a flexible tube, a longitudinal tension is applied to the tube, which is isostatically pressed in a CIP apparatus while maintaining the tension, to form a compact body in the predetermined form of a bar, a wire, a coil, etc., and the compact body is subjected to a treatment for promoting the growth of a superconductive phase, to produce an oxide superconductor in the form of a bar, a wire, a coil, a block, or other desired form.

Example 4

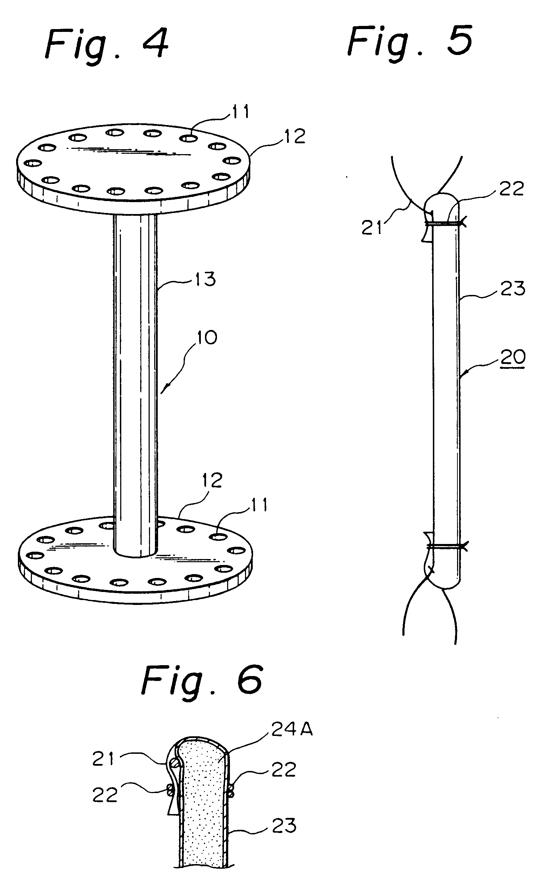

A process and an assembly for producing an oxide superconductor bar according to the present invention will be described below with reference to Figs. 4 to 7.

In Fig. 4, a holder 10 for holding a rubber tube is composed of a pair of holding disks 12 provided with holes 11 for fixing a rubber tube, and a support shaft 13 for supporting the holding disks 12 at the top and the bottom ends thereof.

In Fig. 5, a rubber tube 23 filled with pulverized and agitated granules is folded and tightly sealed with sealing wires 22 on both ends, to which fixing wires 21 are attached, to form a filled rubber tube set 20. The fixing wires 21 are inserted in and fixed to the holes 11 in the holding disks 12 of the holder 10.

Figure 6 shows one end of the filled set 20 in further detail, in which the granules 24A are inserted in the rubber tube 23, both ends of the tube 23 are folded in a manner such that the fixing wires 21 are enclosed in the folded ends, and the folded ends are bound with the sealing wires 22 to seal the granules in the rubber tube 23.

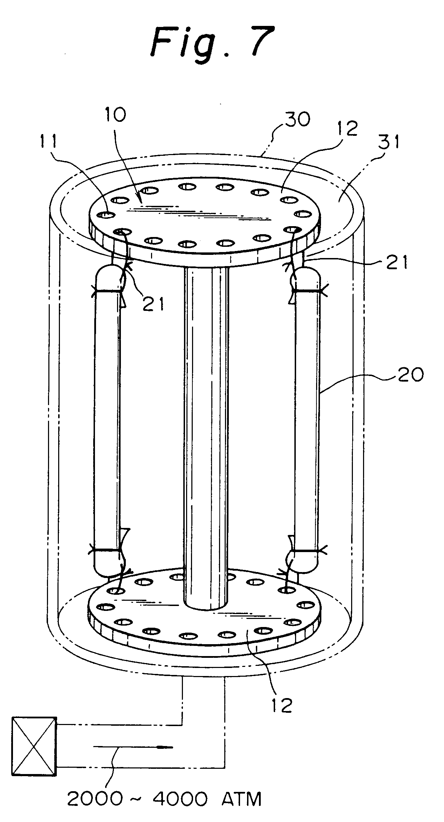

Figure 7 shows a usual CIP arrangement 30 containing the holder 10 on which a plurality of the filled sets 20 are held so that a tension is imparted to the sets 20 along the length thereof.

To hold the filled set 20 on the holder ilo as shown in Fig. 7, the fixing wires 21 attached to the filled set 20 are inserted in the fixing holes 11 and coupled to the holding disks 12, so that the disks 12 impart a tension to the filled sets 20.

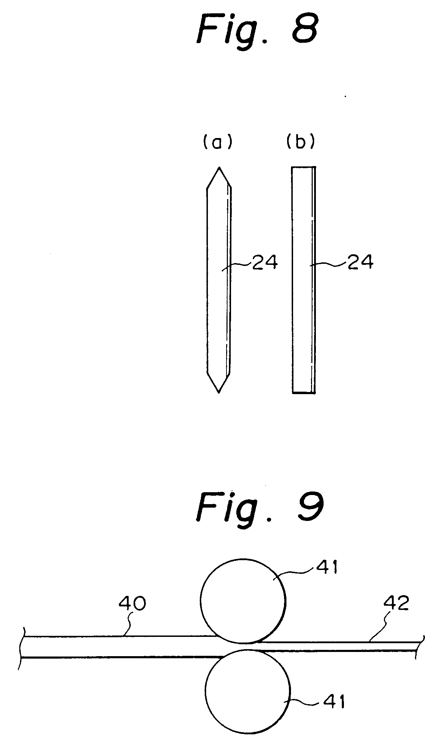

A CIP treatment is carried out by placing the holder 10 with the filled sets 20 in a fluid pressure cylinder 31 of the CIP apparatus 30, and then feeding a pressurized fluid in the cylinder 31 to apply an isostatic high pressure to the filled set 20 at a pressure of $2 \times 10^8$ to $4 \times 10^8$ Pa (2000 to 4000 atm), for example. After the CIP treatment, the holder 10 with the filled sets 20 is taken out of the cylinder 31 of the CIP apparatus 30, the fixing wires 21 are cut, and the folded end of the filled sets 20 is cut to release a precursor bar of an oxide superconductor. Figure 8 shows the thus-obtained precursor bar 24 in side view (a) and front view (b).

This provides a superconductor precursor bar 24 having a uniform diameter and a good straightness, which can be easily inserted in a long crucible vertically positioned in a unidirectional solidification arrangement, to obtain a well-oriented polycrystalline oxide superconductor.

In a floating zone process, the uniform and straight bar 24 can be rotated while ensuring a constant temperature gradient required for producing a well-oriented polycrystalline oxide superconductor.

The thus-produced oxide superconductor has a high density, contains no cracks, has well-oriented uniform polycrystalline structure, and exhibits a superconductive property at the liquid nitrogen temperature.

Example 5

A process for producing an oxide superconductor wire according to the present invention will be described below with reference to Fig. 9.

Granules such as prepared in the preceding Examples are filled in a tube of a metal having a low electrical resistivity, such as copper or silver, and the thus-filled metal tube 40 is subjected to a wire drawing using rolling rolls 41. The thus-obtained wire 42 is imparted with a longitudinal tension, placed in the fluid pressure cylinder 31 of the CIP apparatus 30 shown in Fig. 7, and while maintaining the tension, CIP-treated at a high pressure of $2 \times 10^8$ to $4 \times 10^8$ Pa (2000 to 4000 atm), for example. After the CIP treatment, the wire is annealed in air at 845°C for 12 to 24 hours to ensure a sufficient oxygen content of the product superconductor contained in the tube 40.

The CIP treatment causes a gap to form between the tube 40 and the content, which promotes the oxygen supply for the growth of superconductive $REBa_2Cu_3O_x$ phase, in comparison with the conventional process in which the CIP treatment is not used.

The CIP treatment of the filled tube 40 also provides a superconductor precursor wire coated with a low resistivity metal tube such as copper or silver, etc., and having a uniform diameter and a good straightness.

The coated precursor wire is subjected to a sintering process, a unidirectional solidification, or a floating zone process, etc., to form a dense, uniform, crack-free, and well-oriented polycrystalline oxide superconductor wire coated with a low resistivity metal such as copper or silver, etc.

The oxide superconductor wire having such a coating exhibits a superconductive property at a liquid nitrogen temperature.

The metal coating on a superconductor stabilizes the superconductive properties, and further functions as a protective circuit when the superconductive state is broken.

Example 6

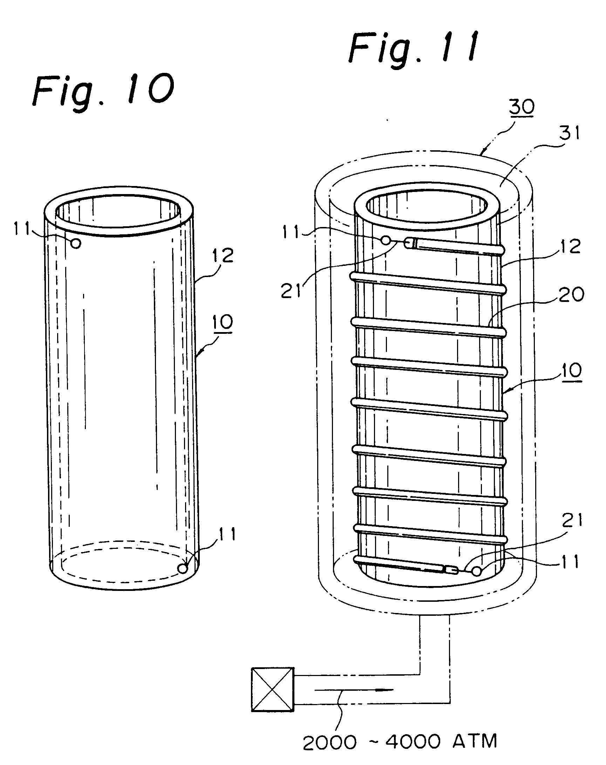

A process and an assembly for producing an oxide superconductor coil according to the present invention will be described below with reference to Figs. 10 and 11.

In Fig. 10, a cylinder 12 provided with holes 11 for fixing a rubber tube is used as a cylindrical holder 10, around which a rubber tube is to be wound.

As shown in Fig. 11, a filled rubber tube set 20 filled with granules in a manner such as shown in Figs. 5 and 6 is wound around the cylindrical holder 10 and fixed on the both ends with fixing wires 21 inserted in the fixing holes 11, so that a tension is imparted to the tube set 20 along the longitudinal direction thereof, i.e., along the circumference of the cylindrical holder 10.

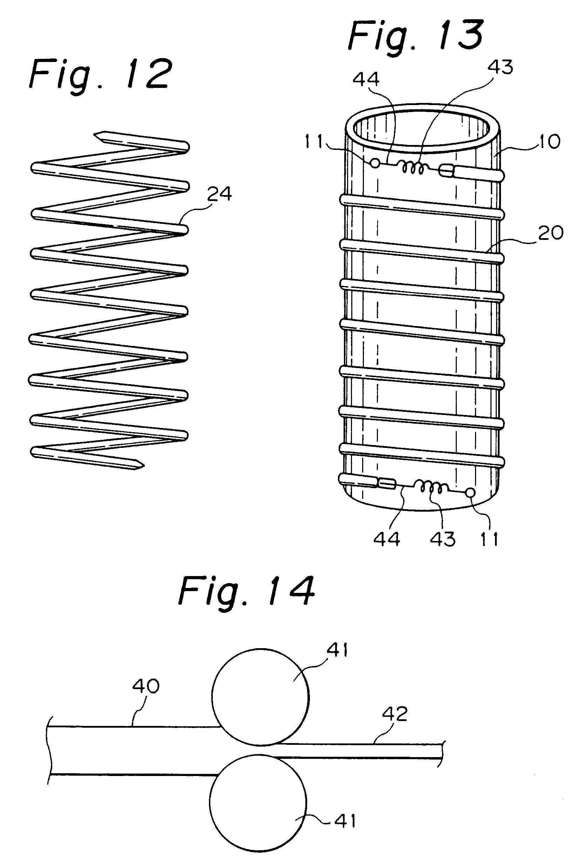

The cylindrical holder 10 with the filled set 20 is placed in a CIP apparatus 30 and CIP-treated in the same manner as in Example 5. After the CIP treatment, the holder 10 with the filled set 20 is taken out of the cylinder 31 of the CIP apparatus 30, the fixing wires 21 are cut, and the folded end of the filled set 20 is cut to release a precursor wire of an oxide superconductor. Figure 12 shows the thus-obtained precursor wire 24 in perspective view.

This provides a crack-free precursor coil of an oxide superconductor having a uniform diameter and a high density.

The crack-free precursor coil having a uniform diameter and a high density is subjected to a sintering process, a unidirectional solidification, a floating zone process, a laser irradiation, or a plasma irradiation, etc., to form a dense, uniform, crack-free, and well-oriented polycrystalline oxide superconductor coil.

The dense, uniform, crack-free, and well-oriented polycrystalline oxide superconductor coil exhibits a superconductive property at liquid nitrogen temperatures.

Example 7

Another process for producing an oxide superconductor coil according to the present invention will be described below with reference to Fig. 13.

Granules 24A (Fig. 6) are filled in a metal tube having a low electrical resistivity, such as copper or silver, and the thus-filled tube 40 is subjected to a wire drawing by rolling rolls 42 to form a wire 42. Fixing hooks 44 are connected to the wire 42 on both ends by means of springs 43. One of the hooks 44 is hung from one of the fixing holes 11 of a cylindrical holder 10, the wire 42 is spirally wound around the holder 10 while imparting a tension to the wire 42, and the other of the hooks 44 is hung from the other of the fixing holes 11, to hold the wire 42 on the holder 10.

A CIP treatment and the subsequent annealing are carried out in the same manner as in Example 5.

The CIP treatment causes a gap to form between the tube 40 and the content, which promotes the oxygen supply for the complete growth of superconductive $REBa_2Cu_3O_x$ phase, in comparison with the conventional process in which the CIP treatment is not used.

The CIP treatment of the filled tube 40 also provides a uniform and crack-free superconductor precursor coil coated with a low resistivity metal tube such as copper or silver, etc., and having a uniform diameter and a high density.

The coated precursor coil is subjected to a sintering process, a unidirectional solidification, a floating zone process, a laser irradiation, or a plasma irradiation, etc., to form a dense, uniform, crack-free, and well-oriented polycrystalline oxide superconductor coil coated with a low resistivity metal such as copper or silver, etc.

The oxide superconductor coil having such a coating exhibits a superconductive property at a liquid nitrogen temperature.

The metal coating on a superconductar stabilizes the superconductive properties, and further functions as a protective circuit when the superconductive state is broken.

In the above-described Examples, the CIP treatment and the re-heating are carried out in separate steps, but a single hot isostatic pressing process may be used for effecting these steps.

As seen from the above description, the process according to the present invention provides an oxide superconductor having a high critical current density achieved by the structure thereof in which fine particles of the $RE_2BaCuO_5$ phase are uniformly dispersed in the $REBa_2Cu_3O_x$ superconductive phase; RE being one or more of rare earth elements including yttrium.

Such a fine and uniform dispersion of the $RE_2BaCuO_5$ phase in the $REBa_2Cu_3O_x$ phase is ensured by the pulverization and agitation step effected so that fine and uniform dispersion of the $RE_2BaCuO_5$ phase in a liquid phase is obtained in the later step of re-heating to a temperature at which an $RE_2BaCuO_5$ phase and the liquid phase coexist.

The present inventive process provides a well-oriented polycrystalline oxide superconductor of an REBaCuO-system, RE being one or more of rare earth elemnts including yttrium, particularly by the steps of: agitating the pulverized granules to an extent such that a fine and uniform dispersion of an $RE_2BaCuO_5$ phase in a liquid phase is obtained in the later step of re-heating; filling the granules in a flexible tube; applying a longitudinal tension to the flexible tube filled with the granules; isostatically pressing the flexible tube, while maintaining the tension, to form a compact body; and subjecting the compact body to a treatment for promoting the growth of the $REBa_2Cu_3O_x$ phase therein, the treatment including the steps of re-heating the compact body to a temperature at which an $RE_2BaCuO_5$ phase and a liquid phase coexist and then cooling the compact body to a temperature at which the $REBa_2Cu_3O_x$ phase and the $RE_2BaCuO_5$-phase coexist.

The present inventive process also provides a well-oriented polycrystalline oxide superconductor of an REBaCO-system, RE being one or more of rare earth elements including yttrium,the superconductor having a high critical current density and a good processability.

It is, of course, obvious that the present invention is not limited to the above-mentioned Examples, and that modifications are possible within the range not exceeding the claimed scope.

**Claims**

1. A process for producing an oxide superconductor of an REBaCuO-system, RE being one or more of rare earth elements includingyttrium, comprising the steps of:

preparing a solid mixture of oxides of the component elements of an oxide superconductor of an REBaCuO-system, the solid mixture having a chemical composition such that a structure substantially composed of an $RE_2BaCuO_5$ phase and an $REBa_2Cu_3O_x$ phase is formed in the later step of cooling;

heating the solid mixture to form a solid-and-liquid mixture of an $RE_2O_3$ phase and a liquid phase, or of an $RE_2BaCuO_5$ phase and a liquid phase;

cooling the solid-and-liquid mixture to cause a peritectic reaction and form a solid body having a structure substantially composed of an $RE_2BaCuO_5$ phase and a $REBa_2Cu_3O_x$ phase;

pulverizing the solid body to form granules;

agitating the granules to an extent such that a fine and uniform dispersion of an $RE_2BaCuO_5$ phase in a liquid phase is obtained in the later step of re-heating;

filling the granules in a flexible tube;

applying a longitudinal tension to the flexible tube filled with the granules;

isostatically pressing the flexible tube, while maintaining the tension, to form a compact body;

relaxing the isostatic pressure and the longitudinal tension; and

subjecting the compact body to a treatment for promoting the growth of the $REBa_2Cu_3O_x$ phase therein, the treatment including the steps of re-heating the compact body to a temperature at which an $RE_2BaCuO_5$ phase and a liquid phase coexist and then cooling the compact body to a temperature at which the $REBa_2Cu_3O_x$ phase and the $RE_2BaCuO_5$-phase coexist.

2. A process according to claim 1, wherein said flexible tube is made of a flexible material such as rubber, copper, or silver.

3. A process according to any of claim 1 and 2, wherein said oxide superconductor of an REBaCuO-system is in the form of a bar, a wire, a coil, or a block.


## Patentansprüche

1. Verfahren zur Herstellung eines oxidischen Supraleiters eines SEBaCuO-Systems, wobei SE eines oder mehrere Elemente der Seltenen Erden einschließlich Yttrium darstellt, das die Schritte umfaßt:

Herstellung eines Feststoffgemisches aus Oxiden der Bestandteilelemente eines oxidischen Supraleiters eines SEBaCuO-Systems, wobei das Feststoffgemisch eine solche chemische Zusammensetzung hat, daß im späteren Schritt der Abkühlung eine Struktur gebildet wird, die im wesentlichen aus einer $SE_2BaCuO_5$-Phase und einer $SEBa_2Cu_3O_x$-Phase zusammengesetzt ist;

Erwärmen des Feststoffgemisches, um ein Fest-Flüssig-Gemisch aus einer $SE_2O_3$ Phase und einer Flüssigphase oder aus einer $SE_2BaCuO_5$-Phase und einer Flüssigphase zu bilden;

Abkühlen des Fest-Flüssig-Gemisches, um eine peritektische Reaktion herbeizuführen und einen Feststoffkörper mit einer Struktur zu bilden, die im wesentlichen aus einer $SE_2BaCuO_5$-Phase und einer $SEBa_2Cu_3O_x$-Phase zusammengesetzt ist;

Pulverisieren des Feststoffkörpers zu Körnchen;

Rühren der Körnchen bis zu einem Grad, bei dem eine feine und einheitliche Dispersion einer $SE_2BaCuO_5$-Phase in einer Flüssigphase im späteren Schritt der Wiedererwärmung erhalten wird;

Füllen der Körnchen in ein flexibles Rohr;

Anwenden einer longitudinalen Spannung an das flexible, mit den Körnchen gefüllte Rohr;

isostatisches Pressen des flexiblen Rohres unter Aufrechterhaltung der Spannung, um einen kompakten Körper zu bilden;

Entspannen des isostatischen Druckes und der longitudinalen Spannung; und

Unterwerfen des kompakten Körpers einer Behandlung zur Steigerung des Wachstums der $SEBa_2Cu_3O_x$-Phase, wobei die Behandlung eine Wiedererwärmung des kompakten Körpers auf eine Temperatur, bei der eine $SE_2BaCuO_5$-Phase und eine Flüssigphase koexistieren und anschließendes Abkühlen des kompakten Körpers auf eine Temperatur, bei der die $SEBa_2Cu_3O_x$-Phase und die $SE_2BaCuO_5$-Phase koexistieren, einschließt.

2. Verfahren nach Anspruch 1, worin das flexible Rohr aus einem flexiblen Material, wie z.B. Gummi, Kupfer oder Silber, hergestellt ist.

3. Verfahren nach einem der Ansprüche 1 oder 2, worin der oxidische Supraleiter eines SEBaCuO-Systems in Form eines Barrens, eines Drahtes, einer Spirale oder eines Blocks vorliegt.

**Revendications**

1. Procédé de fabrication d'un oxyde supraconducteur constitué d'un système REBaCuO, RE représentant un ou plusieurs éléments des terres rares, l'yttrium, et comprenant les étapes consistant :

à préparer un mélange solide d'oxydes des éléments constituants d'un oxyde supraconducteur d'un système REBaCuO, le mélange solide ayant une composition chimique telle qu'il se forme au cours de la dernière étape de refroidissement une structure essentiellement constituée d'une phase $RE_2BaCuO_5$ et d'une phase $REBa_2Cu3O_x$ ;

à chauffer le mélange solide pour former un mélange solide et liquide constitué d'une phase $RE_2O_3$ et d'une phase liquide, ou d'une phase $RE_2BaCu_5O_5$ et d'une phase liquide ;

à refroidir le mélange solide et liquide pour provoquer une réaction péritectique et former un corps solide ayant une structure essentiellement constituée d'une phase $RE_2BaCuO_5$ et d'une phase $REBa_2Cu_3O_x$ ;

à pulvériser le corps solide pour former des granules ;

à agiter les granules jusqu'à ce que l'on obtienne, au cours de la dernière étape de rechauffage, une dispersion fine et uniforme d'une phase $RE_2BaCuO_5$ dans une phase liquide ;

à introduire les granules dans un tube souple ;

à appliquer une traction longitudinale au tube souple rempli des granules ;

à comprimer par compression isostatique le tube souple, toute en maintenant la traction, pour former un corps comprimé ;

à détendre la pression isostatique et la traction longitudinale ; et

à soumettre le corps comprimé à un traitement pour favoriser la croissance en son sein, de la phase $REBa_2Cu_3O_x$, le traitement comprenant les étapes consistant à rechauffer le corps comprimé à une température à laquelle il y a coexistence entre la phase $RE_2BaCuO_5$ et une phase liquide, puis à refroidir le corps comprimé à une température à laquelle il y a coexistence de la phase $REBa_2Cu_3O_x$ et de la phase $RE_2BaCuO_5$.

2. Procédé selon la revendication 1, dans lequel le tube souple est réalisé en un matériau souple tel que le caoutchouc, le cuivre ou l'argent.

3. Procédé selon l'une quelconque des revendications 1 et 2, dans lequel l'oxyde supraconducteur, constitué d'un système REBaCuO, se présente sous forme d'une barre, d'un fil, d'une bobine ou d'un bloc.

# Fig. 1

Fig. 2

# Fig. 3

# Fig. 4

# Fig. 5

# Fig. 6

# Fig. 7

2000 ~ 4000 ATM

# Fig. 8

(a)    (b)

~24      ~24

# Fig. 9

~41

40      42

~41

# Fig. 10

# Fig. 11

2000 ~ 4000 ATM

Fig. 12

24

Fig. 13

44    43

11    10

20

44    43    11

Fig. 14

40    41

42

41